Europäisches Patentamt

European Patent Office

Office européen des brevets

(11) Numéro de publication: **0 195 696**
**B1**

(12) **FASCICULE DE BREVET EUROPEEN**

(45) Date de publication du fascicule du brevet:
02.08.89

(51) Int. Cl.⁴: **H01L 21/82**

(21) Numéro de dépôt: **86400320.7**

(22) Date de dépôt: **14.02.86**

(54) Procédé de réalisation de deux structures MOS à diélectriques juxtaposés différents et dopages différents et matrice à transfert de trame obtenue par ce procédé.

(30) Priorité: **19.02.85 FR 8502366**

(43) Date de publication de la demande:
**24.09.86 Bulletin 86/39**

(45) Mention de la délivrance du brevet:
**02.08.89 Bulletin 89/31**

(84) Etats contractants désignés:
**DE GB NL**

(56) Documents cités:
**US-A- 3 865 652**
**US-A- 4 065 847**
**US-A- 4 077 112**

**PATENTS ABSTRACTS OF JAPAN,**
**vol. 5, no. 30 (E-47)[702], 24 février 1981 & JP - A**
**- 55 158 674**
**PATENTS ABSTRACTS OF JAPAN,**
**vol. 7, no. 58 (E-163)[1203], 10 mars 1983 & JP - A**
**- 57 204 165**

**Le dossier contient des informations techniques présentées postérieurement au dépôt de la demande et ne figurant pas dans le présent fascicule.**

(73) Titulaire: **THOMSON-CSF, 51, Esplanade du Général de Gaulle, F-92800 Puteaux(FR)**

(72) Inventeur: **Blanchard, Pierre, THOMSON-CSF SCPI 19, Avenue de Messine, F-75008 Paris(FR)**

(74) Mandataire: **Lincot, Georges et al, THOMSON-CSF SCPI, F-92045 PARIS LA DEFENSE CEDEX 67(FR)**

## Description

La présente invention concerne un procédé de réalisation de deux structures MOS à diélectriques juxtaposés différents et à dopages différents sur un substrat semiconducteur, pour isoler de façon différente les régions du substrats où le canal est situé en surface et celles où le canal est situé en volume. Une matrice à transfert de trame peut être obtenue par ce procédé.

Il est connu pour obtenir un bon isolement entre une électrode de grille et un substrat dans les dispositifs à transfert de charge de placer entre la grille et le substrat une double couche de diélectrique comportant une première couche de dioxyde de silicium au contact avec le substrat et une deuxième couche de nitrure de silicium recouvrant la première couche.

Cette double couche de diélectrique qui recouvre à la fois les régions du substrat où le canal se situe en surface et les régions où celui-ci se situe en volume, occasionne des variations dans le comportement électronique des circuits construits de cette façon, et engendre, notamment dans les dispositifs semiconducteurs optoélectroniques à transfert de charge, des variations dans les seuils et les caractéristiques de conduction des transistors MOS les constituant ce qui nuit au bon fonctionnement de ces dispositifs.

Une manière de remédier à ces difficultés serait de ne réaliser sur le substrat qu'une simple couche d'oxyde en regard des régions où le canal se situe en surface et une double couche d'oxyde dans les régions du substrat où le canal est réparti en volume, ce qui aurait pour avantage de conserver pour les circuits optoélectroniques à transfert de charge la double couche sur la plus grande partie de ces circuits.

Mais la précision du positionnement des zones de transition entre simple et double couche et les grilles ou électrodes qui leurs sont associées dépendrait entièrement dans cette solution de celle des machines photolithographiques et rendrait cette solution onéreuse et mal adaptée aux productions en grande série.

Le but de l'invention est de pallier les inconvénients précités.

A cet effet, l'invention a pour objet, un procédé de réalisation de deux structures MOS à diélectriques juxtaposés différents et à dopages différents sur un substrat semiconducteur, pour isoler de façons différentes les régions du substrat où le canal est situé en surface et celles où le canal est situé en volume caractérisé en ce qu'il consiste, à réaliser sur une surface d'un substrat une première couche d'oxyde de silicium puis une deuxième couche de nitrure de silicium au-dessus de la première couche, à attaquer par photolythogravure la deuxième couche de nitrure de silicium pour former une première fenêtre et délimiter les régions d'isolement, à faire croître à l'intérieur de la fenêtre un oxyde épais d'isolement autoaligné à la double couche d'oxyde et de nitrure, à substituer la double couche d'oxyde et de nitrure de silicium par une troisième couche d'oxyde de silicium formant le premier diélectrique, à déposer une quatrième couche d'un matériau formé par du silicium dopé, à graver dans la quatrième couche une deuxième fenêtre pour délimiter à l'aide du masque ainsi formé une région de canal en volume, à mettre à nu la surface du substrat délimitée par la deuxième fenêtre et par l'oxyde épais, à doper le substrat au travers de la deuxième fenêtre, à oxyder puis à déposer une double couche de dioxyde de silicium et de nitrure de silicium au-dessus de la couche de silicium dopée et de la partie mise à nu du substrat, à retirer la double couche de dioxyde de silicium et de nitrure de silicium au-dessus de la quatrième couche de silicium dopée qui a servi de masque pour l'obtention de la deuxième fenêtre, à déposer au-dessus de la quatrième couche de silicium dopée et de la double couche de dioxyde de silicium et de nitrure de silicium restante recouvrant la deuxième fenêtre une cinquième couche de silicium et à graver une cinquième couche de silicium dopée ainsi que la couche de silicium pour former une grille.

D'autres caractéristiques et avantages de l'invention apparaîtront à l'aide de la description faite au regard des dessins annexés donnés uniquement à titre d'exemple et dans lesquels

les figures 1 à 10 représentent les différentes phases du procédé selon l'invention,

la figure 11 illustre une variante de réalisation du procédé selon l'invention,

les figures 12 à 15 représentent le principe de réalisation d'un système antiéblouissement d'une matrice à transfert de trame obtenue à l'aide du procédé selon l'invention.

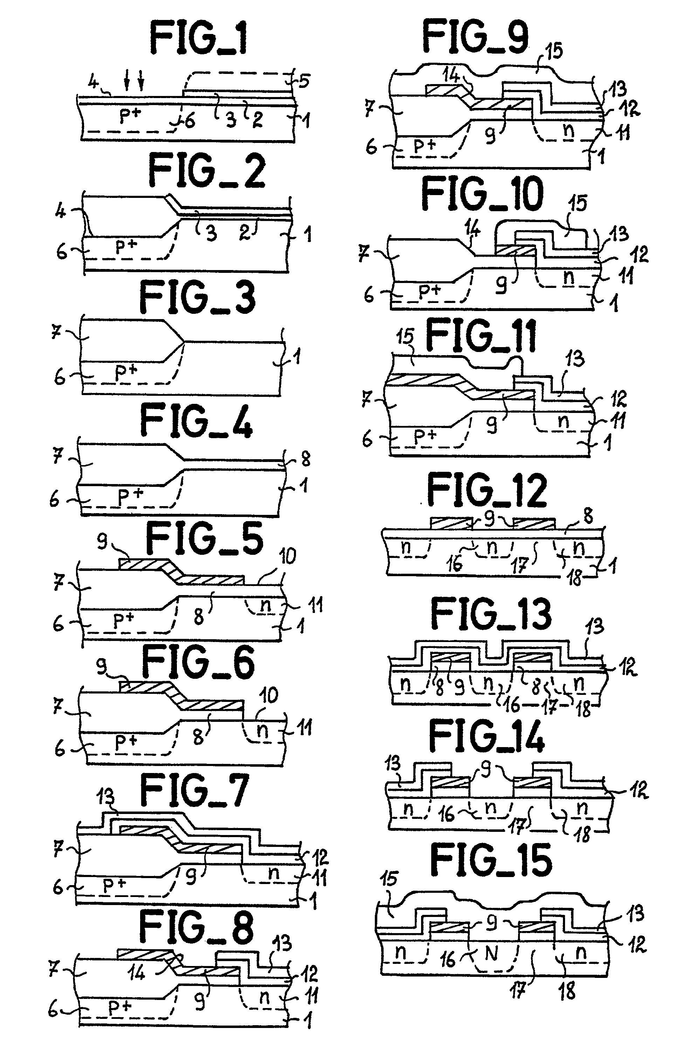

La première étape du procédé selon l'invention qui est représentée à la figure 1, consiste à réaliser sur la surface supérieure d'un substrat 1 une première couche d'oxyde de silicium 2 puis une deuxième couche de nitrure de silicium 3 au-dessus de la première couche et enfin à former une fenêtre 4 à l'aide d'un masque 5 par une photolythogravure pour implanter à travers la fenêtre 4 des particules de Bore dans une région 6 en volume à l'intérieur du substrat en regard de la fenêtre 4, afin d'isoler les parties actives du circuit. L'étape suivante représentée à la figure 2 consiste à faire croître un oxyde épais d'isolement au-dessus du substrat 1 dans la région délimitée par la fenêtre 4. La double couche d'oxyde 2 et de nitrure de silicium 3 est retirée à l'étape représentée à la figure 3 et est remplacée par une autre couche d'oxyde 8 de silicium pour former une simple couche, et une mince couche de silicium dopée par exemple au phosphore est déposée à l'étape représentée sur la figure 5 au-dessus de la simple couche 8 puis est gravée par une photolithographie pour déterminer une zone de canal en volume en regard d'une fenêtre 10 dans une région en volume 11 du substrat 1 située en regard de la fenêtre 10. A l'étape représentée à la figure 6, la surface du substrat 1 est mise à nu dans la fenêtre 10 de manière à permettre l'implantation par exemple d'arsenic dans la région en volume 11 en regard de la fenêtre 10. A l'étape suivante, représentée à la figure 7, une double couche de silice et de nitrure de silicium est réalisée au-dessus de la couche de silicium dopé au phosphore 9 et de la fenêtre 10 et est oxydée pour former un diélectrique de bonne qualité. A l'étape représentée à la figure 8 une photolithogravure est réalisée pour retirer la double couche d'oxyde et de nitrure 12 et 13 au-dessus de la couche de silicium dopée 9 à l'aide d'un masque placé au-dessus de la région dopée en regard de la fenêtre 10. Enfin, à l'étape représentée à la figure 9, un dépôt de silicium dopé 15 est réalisé sur l'ensemble des couches précédemment décrites, de façon à former, à l'étape représentée à la figure 10, une grille 15 au-dessus de la zone de transition entre la double couche d'oxyde et de nitrure 12, 13 et la simple couche d'oxyde 8, et former une grille au-dessus de cette zone de transition.

Le procédé qui vient d'être décrit permet de graver une grille au-dessus d'une zone de transition délimitant une simple et une double couche d'oxyde, la grille étant constituée par les deux dépôts de silicium. Ce même procédé pourra être mis en oeuvre pour un circuit possédant deux niveaux de grilles silicium. Pour cela on pourra conserver dans la partie réservée à la formation de la grille le silicium mince recouvert de la double couche comme ceci est représenté à la figure 7. Selon cette configuration le niveau de grille 1 est gravé. Sur le nitrure ainsi à nu l'oxyde d'isolement entre niveaux de grille ne change pas la structure. Une photolithogravure permet de retirer la double couche de façon à se mettre dans les mêmes conditions que celles représentées à la figure 8 à la différence toutefois que le deuxième niveau de grille remplace le premier niveau.

Le procédé selon l'invention qui vient d'être décrit est également applicable à l'obtention de grilles autoalignées à la zone de transition entre simple et double couche ou à l'obtention de grilles dont le diélectrique est mixte : à la fois simple et double couche. Dans le premier cas le procédé selon l'invention qui vient d'être décrit reste applicable et seul le positionnement de la grille concernée diffère, celui-ci devant s'effectuer au-dessus du premier dépôt de la couche mince de silicium 9 qui définit dans ce cas la zone d'autoalignement comme ceci est représenté à la figure 11. Dans le deuxième cas, les étapes du procédé restent encore les mêmes au positionnement près figure 10. Le simple fait de garder où non la couche mince de silicium 9 avant de réaliser la double couche de silice et de nitrure de silicium permet de déterminer les zones de simple ou double couche.

Un exemple d'application du procédé selon l'invention à la réalisation de matrices à transfert de trame utilisant un système antiéblouissement est décrit ci-après à l'aide des figures 12 à 15. Dans les systèmes antiéblouissement des matrices à transfert de trame, une diode est formée à partir d'une des deux grilles qui composent chaque pixel de la matrice à transfert de charge formant le système. Une barrière de potentiel due à la non implantation d'impureté inverse au substrat forme une zone de transfert qui isole la diode des capacités réservoirs servant au transfert des charges et les charges en excès sont éliminées par la diode ainsi formée et ceci de façon permanente. Une des grilles qui compose la matrice à transfert de trame est située en partie au-dessus d'une région où le canal se situe en surface. Cette région sépare la diode de collection qui élimine les charges en excès d'une région où le canal se situe en volume. Le procédé selon l'invention permet la réalisation de ce système de la façon représentée par les figures 12 à 15. Sur la figure 12 après avoir réalisé l'oxyde de grille 8 servant de diélectrique pour isoler les régions du substrat 1 où le canal est situé en surface une mince couche de silicium 9 est déposée puis gravée. Cette gravure délimite une région 16 où la diode de collection doit être formée, une région 17 où le canal est situé en surface pour le substrat 1 et une région 18 où le canal est situé en volume à l'intérieur du substrat 1. A l'étape suivante représentée à la figure 13, la mise à nu du substrat dans les fenêtres ainsi pratiquées est effectuée et une double couche de silice et de nitrure de silicium 12, 13 est déposée pour former le diélectrique au-dessus de la partie où le canal est situé en volume. Une photolythogravure de la double couche de silice et de nitrure de silicium est effectuée à l'étape représentée à la figure 14 pour remettre à nu la partie où la région du substrat 17 où la diode de collection doit être formée. La diode de collection est ensuite formée à l'étape représentée à la figure 15 en déposant du silicium dopé 15 qui après gravure, forme le niveau de la grille du système antiéblouissement.

**Revendications**

1. Procédé de réalisation de deux structures MOS à diélectriques juxtaposés différents et à dopages différents sur un substrat semiconducteur, pour isoler de façons différentes les régions du substrat où le canal est situé en surface et celles où le canal est situé en volume caractérisé en ce qu'il consiste, à réaliser sur une surface d'un substrat (1) une première couche d'oxyde de silicium (2) puis une deuxième couche de nitrure de silicium (3) au-dessus de la première couche, à attaquer par photolithogravure la deuxième couche (3) de nitrure de silicium pour former une première fenêtre (4) et délimiter les régions d'isolement (1), à faire croître à l'intérieur de la fenêtre (4) un oxyde (7) épais d'isolement autoaligné et à la double couche d'oxyde et de nitrure (3), à substituer la double couche d'oxyde et de nitrure de silicium (3) par une troisième couche d'oxyde de silicium (8) formant le premier diélectrique, à déposer une quatrième couche (9) d'un matériau formé par du silicium dopé, à graver dans la quatrième couche (9) une deuxième fenêtre (10) pour délimiter à l'aide du masque ainsi formé une région de canal en volume (11), à mettre à nu la surface du substrat délimitée par la deuxième fenêtre (10) et par l'oxyde épais (7), à doper le substrat au travers de la deuxième fenêtre (10), à oxyder puis déposer une double couche (12, 13) de dioxyde de silicium et de nitrure de silicium au-dessus de la couche de silicium (9) dopée et la partie mise à nu du substrat, à retirer la double couche (12, 13) de dioxyde de silicium et de nitrure de silicium au-dessus de la quatrième couche de silicium (9) dopée qui a servi de masque pour l'obtention de la deuxième fenêtre (10), et à déposer au-dessus de la quatrième couche de silicium (9) dopée et de la double couche de dioxyde de silicium et de nitrure de silicium (12, 13) restante recouvrant la deuxième fenêtre (10) une cinquième couche de silicium (15) et à graver une cinquième couche (15) de silicium dopée ainsi que la couche de silicium (9) pour former une grille.

2. Procédé selon la revendication 1, caractérisé en ce qu'il consiste à graver la quatrième (9) et la cinquième couche (15) de silicium pour former la grille au-dessus de la zone de transition entre la troisième couche d'oxyde de silicium (8) et la double couche (12, 13) de dioxyde de silicium (12) et de nitrure de silicium (13) recouvrant la deuxième fenêtre (10).

3. Procédé selon la revendication 1, caractérisé en ce qu'il consiste à graver la quatrième (9) et la cinquième couche (15) de silicium pour garder l'auto-alignement constitué par la quatrième couche (9) de silicium à la zone de transition entre la troisième couche d'oxyde de silicium (8) et la double couche (12, 13) de dioxyde de silicium (12) et de nitrure de silicium (13) recouvrant la deuxième fenêtre (10).

4. Procédé selon la revendication 1, caractérisé en ce qu'il consiste à graver la cinquième couche (15) de silicium et la quatrième couche (9) de silicium dans une zone dont le diélectrique est constitué par une simple couche 8 pour obtenir une grille ou électrode dont le canal se situe en surface.

5. Procédé selon la revendication 1, caractérisé en ce qu'il consiste à graver la cinquième couche (15) de silicium dans une zone dont le diélectrique est constitué par la double couche (12, 13) de dioxyde de silicium (12) et de nitrure de silicium (13) pour obtenir une grille ou électrode dont le canal se situe en volume.

6. Procédé selon l'une quelconque des revendications 1 à 5, caractérisé en ce que le substrat (1) est dopé en volume à l'intérieur de la deuxième fenêtre (10) par de l'arsenic, ou du phosphore.

**Patentansprüche**

1. Verfahren zur Herstellung von MOS-Strukturen mit verschiedenen nebeneinanderliegenden Dielektrika und mit verschiedener Dotierung auf einem Halbleitersubstrat, um die Bereiche des Substrats, wo der Kanal an der Oberfläche liegt, und diejenigen, wo der Kanal im Volumen liegt, auf verschiedene Art zu isolieren, dadurch gekennzeichnet, daß es darin besteht, auf einer Fläche eines Substrats (1) eine erste Schicht (2) aus Siliziumoxid und dann eine zweite Schicht (3) aus Siliziumnitrid (3) über der ersten Schicht zu bilden; die zweite Schicht (3) aus Siliziumnitrid durch photolithographische Gravur anzugreifen, um ein erstes Fenster (4) zu bilden und die Isolierbereiche (1) abzugrenzen; innerhalb des Fensters (4) ein dickes Isolieroxid (7) anwachsen zu lassen, das zu der doppelten Schicht (3) aus Oxid und Nitrid selbstausgerichtet ist; die doppelte Schicht (3) aus Oxid und Siliziumnitrid durch eine dritte Schicht (8) aus Siliziumoxid, welche das erste Dielektrikum bildet, zu ersetzen; eine vierte Schicht (9) aus einem mit dotiertem Silizium gebildeten Material aufzubringen; in die vierte Schicht (9) ein zweites Fenster (10) einzugravieren, um mittels dieser so gebildeten Maske einen Kanalbereich (11) im Volumen abzugrenzen; die durch das zweite Fenster (10) und durch das dicke Oxid (7) abgegrenzte Fläche des Substrats bloßzulegen; das Substrat über das zweite Fenster (10) zu dotieren; eine doppelte Schicht (12, 13) aus Siliziumdioxid und Siliziumnitrid über der dotierten Schicht (9) aus Silizium und über dem bloßgelegten Teil des Substrats aufzubringen; die doppelte Schicht (12, 13) aus Siliziumdioxid und aus Siliziumnitrid über der vierten Schicht (9) aus dotiertem Silizium teilweise mittels einer Maske zu entfernen, die über den dotierten Bereich gegenüber dem zweiten Fenster (10) aufgelegt wird; und über der vierten dotierten Schicht (9) aus Silizium sowie über der verbleibenden, doppelten Schicht aus Siliziumdioxid und aus Siliziumnitrid (12, 13), welche das zweite Fenster (10) bedeckt, eine fünfte Schicht (15) aus Silizium sowie die Schicht (9) aus Silizium einzugravieren, um ein Gate zu bilden.

2. Verfahren nach Anspruch 1, dadurch gekennzeichnet, daß es darin besteht, die vierte Schicht (9) aus Silizium sowie die fünfte Schicht (15) aus Silizium einzugravieren, um das Gate über der Übergangszone zwischen der dritten Schicht (8) aus Siliziumoxid und der doppelten Schicht (12, 13) aus Siliziumdioxid (12) und aus Siliziumnitrid (13), welche das zweite Fenster (10) bedecken, zu bilden.

3. Verfahren nach Anspruch 1, dadurch gekennzeichnet, daß es darin besteht, die vierte Schicht (9) aus Silizium sowie die fünfte Schicht (15) aus Silizium einzugravieren, um die Selbstausrichtung zu bewahren, die durch die vierte Schicht (9) aus Silizium zu der Übergangszone zwischen der dritten Schicht (8) aus Siliziumoxid und der doppelten Schicht (12, 13) aus Siliziumdioxid (12) und aus Siliziumnitrid (13) gebildet ist, welche das zweite Fenster (10) bedecken.

4. Verfahren nach Anspruch 1, dadurch gekennzeichnet, daß es darin besteht, die fünfte Schicht (15) aus Silizium und die vierte Schicht (9) aus Silizium in einer Zone einzugravieren, deren Dielektrikum durch eine einfache Schicht 8 gebildet ist, um ein Gate oder eine Elektrode, dessen bzw. deren Kanal sich an der Oberfläche befindet, zu erhalten.

5. Verfahren nach Anspruch 1, dadurch gekennzeichnet, daß es darin besteht, die fünfte Schicht (15) aus Silizium in einer Zone einzugravieren, deren Dielektrikum durch die doppelte Schicht (12, 13) aus Siliziumdioxid (12) und aus Siliziumnitrid (13) gebildet ist, um ein Gate oder eine Elektrode, dessen bzw. deren Kanal im Volumen liegt, zu erhalten.

6. Verfahren nach einem der Ansprüche 1 bis 5, dadurch gekennzeichnet, daß das Substrat (1) bis in sein Volumen innerhalb des zweiten Fensters (10) mit Arsen oder mit Phosphor dotiert wird.

**Claims**

1. A method of producing MOS structures with different juxtaposed dielectrics and different doping rates on a semiconductor substrate, in order to insulate the different regions of the substrate where the channel is situated on the surface and those where the channel is situated in the material, characterized in that it consists of producing, on a surface of substrate (1), a first layer of silicon oxide (2), then a second layer of silicon nitride (3) above the first layer, of photolytically engraving the second layer (3) of silicon nitride in order to form a first window (4) and to delimit the insulating regions (1), of growing, inside the window (4), a thick insulating oxide (7) self aligned with the double oxide layer and of nitride (3), of substituting the double layer of oxide and nitride (3) by a third layer (8) of silicon oxide forming the first dielectric, of placing a fourth layer (9) of a material formed by doped silicon, of engraving in the fourth layer (9) a second window (10) in order to delimit with the aid of the mask so formed a channel region in the material (11), of exposing the surface of the substrate delimited by the second window (10) and by the thick oxide (7), of doping the substrate through the second window (10), placing a double layer (12 and 13) of silicon dioxide and of silicon nitride over the silicon doped layer (9) and of the part of the substrate exposed, of partly withdrawing the double layer (12 and 13) of the silicon dioxide and of silicon nitride over the fourth layer of doped silicon (9) with the aid of a mask placed over the doped region opposite to the second window (10), and of placing over the fourth layer of doped silicon (9) and over the double layer of silicon dioxide and of silicon nitride (12 and 13) remaining and still covering the second window (10) a fifth layer (15) and engraving the fifth layer (15) of doped silicon as well as the layer (9) of silicon to form a gate.

2. The method as claimed in claim 1, characterized in that it consists in engraving the fourth layer (9) and the fifth layer (15) of silicon in order to form the gate over the transition zone between the third layer (8) of silicon and the double layer (12 and 13) of silicon dioxide (12) and of silicon nitride (13) covering the second window (10).

3. The method as claimed in claim 1, characterized in that it consists of engraving the fourth layer (9) and the fifth layer (15) of silicon in order to maintain the selfalignment constituted by the fourth layer (9) of silicon at the zone of transition between the third layer (8) of silicon oxide and the double layer (12 and 13) of silicon dioxide (12) and of silicon nitride (13) covering the second window (10).

4. The method as claimed in claim 1, characterized in that it consists of engraving the fifth layer (15) of silicon and the fourth layer (9) of silicon in a zone whose dielectric is constituted by a plain layer 8 in order to obtain a gate or an electrode whose channel is situated on the surface.

5. The method as claimed in claim 1, characterized in that it consists in engraving the fifth layer (15) of silicon in a zone whose dielectric is constituted by the double layer (12 and 13) of silicon dioxide (12) and of silicon nitride (13) in order to obtain a gate or an electrode whose channel is situated in the material.

6. The method as claimed in any one of the claims 1 through 5, characterized in that the substrate (1) is doped in the material within the second window (10) by arsenic or by phosphorus.

FIG_1

FIG_2

FIG_3

FIG_4

FIG_5

FIG_6

FIG_7

FIG_8

FIG_9

FIG_10

FIG_11

FIG_12

FIG_13

FIG_14

FIG_15